# EUROPÄISCHE PATENTSCHRIFT

(11) **EP 1 259 990 B1**
(45) Veröffentlichungstag und Bekanntmachung des Hinweises auf die Patenterteilung: **25.12.2013**
(21) Anmeldenummer: 01919164.2
(22) Anmeldetag: 02.03.2001
(51) Int. Cl.: H01L 33/50

(54) **VERFAHREN ZUR HERSTELLUNG EINES LICHTABSTRAHLENDEN HALBLEITERKÖRPERS MIT LUMINESZENZKONVERSIONSELEMENT**
METHODS FOR PRODUCING A LIGHT EMITTING SEMICONDUCTOR BODY WITH A LUMINESCENCE CONVERTER ELEMENT
PROCEDE DE REALISATION D'UN CORPS SEMI-CONDUCTEUR EMETTEUR DE LUMIERE AVEC UN ELEMENT DE CONVERSION DE LUMINESCENCE

(30) Priorität: 03.03.2000 DE 10010638
(43) Veröffentlichungstag der Anmeldung: 27.11.2002
(73) Patentinhaber: OSRAM Opto Semiconductors GmbH, 93055 Regensburg (DE)
(72) Erfinder: BOGNER, Georg, 93138 Lappersdorf (DE); DEBRAY, Alexandra, 91058 Erlangen (DE); WAITL, Günther, 93049 Regensburg (DE)
(74) Vertreter: Epping - Hermann - Fischer
(86) Internationale Anmeldenummer: PCT/DE2001/000798
(87) Internationale Veröffentlichungsnummer: WO 2001/065613

(56) Entgegenhaltungen:
- EP-A1- 1 051 758
- EP-A1- 1 051 759
- EP-A2- 0 884 370
- EP-A2- 1 111 689
- WO-A-97/50132
- DE-U- 29 804 149
- PATENT ABSTRACTS OF JAPAN vol. 1999, no. 05, 31. Mai 1999 (1999-05-31) -& JP 11 031845 A (NICHIA CHEM IND LTD), 2. Februar 1999 (1999-02-02)
- PATENT ABSTRACTS OF JAPAN vol. 1999, no. 05, 31. Mai 1999 (1999-05-31) -& JP 11 046019 A (NICHIA CHEM IND LTD), 16. Februar 1999 (1999-02-16)

## Beschreibung

Die Erfindung bezieht sich auf ein Verfahren zur Herstellung eines lichtabstrahlenden Halbleiterkörpers mit Lumineszenzkonversionselement nach dem Oberbegriff von Patentanspruch 1 beziehungsweise Patentanspruch 2.

Lichtabstrahlende Halbleiterbauteile mit Lumineszenzkonversionselement sind beispielsweise aus WO 97/50132 bekannt. Diese Anordnungen enthalten einen Halbleiterkörper, der im Betrieb Licht aussendet (Primärlicht), und ein Lumineszenzkonversionselement, das einen Teil dieses Lichts in einen anderen Wellenlängenbereich konvertiert (Fluoreszenzlicht). Der Farbeindruck des von einem solchen Halbleiterbauelement emittierten Lichts ergibt sich durch additive Farbmischung aus Primärlicht und Fluoreszenzlicht.

DE 29 804 149 U1 beschreibt eine LED-Vorrichtung mit einer auf der Oberfläche oder Umgebung des Kristallelements bzw. Kristallkorns aufgetragene Puderschicht, womit eine LED weisses oder farbiges Licht erzeugt.

Das Lumineszenkonversionselement kann in verschiedener Weise dem Halbleiterkörper nachgeordnet sein. In vielen Ausführungsformen besteht das Lumineszenzkonversionselement aus Leuchtstoffen, die in einer den Halbleiterkörper umgebenden Vergußmasse eingebettet sind.

Diese Anordnungen besitzen den Nachteil, daß aufgrund von Sedimentation der Leuchtstoffe in der Vergußmasse die Leuchtstoffe räumlich inhomogen verteilt sind. Weiterhin sind die Quellen von Primärlicht - Halbleiterkörper - und von Fluoreszenzlicht - Vergußmasse mit Leuchtstoff - im allgemeinen von verschiedener Form und Größe, so daß ein räumlich inhomogener Farbeindruck entsteht und bei optischen Abbildungen starke chromatische Fehler auftreten. Ein weiterer Nachteil besteht darin, daß der Farbeindruck von der optischen Weglänge in der Vergußmasse abhängt, so daß fertigungsbedingte Schwankungen der Vergußmassendicke zu verschiedenen Farbeindrücken führen.

Ist ein gleichmäßiger Farbeindruck in verschiedene Beobachtungsrichtungen erforderlich, so ist weiterhin die Formgebung der Bauelemente dadurch nachteilig limitiert, daß die optische Weglänge in der Vergußmasse für alle gewünschten Beobachtungsrichtungen annähernd gleich sein sollte.

In der oben genannten Druckschrift ist weiterhin angegeben, daß der Leuchtstoff auch direkt auf dem Halbleiterkörper aufgebracht sein kann. Durch diese Anordnung werden die vorgenannten Nachteile umgangen.

Der vorliegenden Erfindung liegt die Aufgabe zugrunde, ein Verfahren zu entwickeln, das die direkte Aufbringung des Leuchtstoffs auf einen Halbleiterkörper ermöglicht.

Diese Aufgabe wird durch ein Verfahren nach Anspruch 1 gelöst. Vorteilhafte Weiterbildungen der Erfindung sind Gegenstand der Ansprüche 2 bis 7.

Erfindungsgemäß wird im ersten Verfahrensschritt der Halbleiterkörper nach einem üblichen Verfahren gefertigt, auf einen Träger montiert und mit Kontakten versehen. Im zweiten Schritt wird der Leuchtstoff zusammen mit einem Haftvermittler in einem Butylazetat enthaltenden Lösungsmittel suspendiert. Diese Suspension wird schichtartig auf den Halbleiterkörper aufgebracht durch Aufsprühen oder Auftropfen. In einem dritten Schritt wird das Bauelement getrocknet, wobei das Lösungsmittel entweicht und der Leuchtstoff mit dem Haftvermittler auf dem Halbleiterkörper zurückbleibt.

Ein weiteres Verfahren (nicht Teil dieser Erfindung) besteht darin, in einem ersten Verfahrensschritt den Halbleiterkörper zu fertigen, auf einen Träger zu montieren und mit Kontakten zu versehen. Im zweiten Schritt wird der Halbleiterkörper mit einem Haftvermittler beschichtet. Im dritten Schritt wird auf diese Haftvermittlerschicht der Leuchtstoff aufgebracht.

In einer bevorzugten Ausführung dieses Verfahrens wird als Haftvermittler Epoxidharz, Acrylharz oder Silikon verwendet. Diese Materialien werden oftmals bei der Fertigung von Leuchtdioden eingesetzt und können daher kostengünstig für die erfindungsgemäßen Verfahren herangezogen werden.

In einer besonders bevorzugten Ausführung des letzteren Verfahrens wird der Leuchtstoff auf den Haftvermittler aufgestreut. Durch diese Methode läßt sich eine gleichmäßige, wohl dosierte Leuchtstoffschicht auf den Halbleiterkörper aufbringen. Alternativ kann der Leuchtstoff auch aufgeblasen oder aufgestäubt werden.

Als Leuchtstoff werden vorzugsweise anorganische Phosphore wie mit Seltenen Erden, insbesondere Ce, dotierte Granate, Erdalkalisulfide, Thiogallate, Aluminate und Orthosilikate verwendet. Effiziente Leuchtstoffe sind hierbei Verbindungen, die der Formel A₃B₅O₁₂:M genügen (sofern sie nicht unter den üblichen Herstellungs- und Betriebsbedingungen instabil sind). Darin bezeichnet A mindestens ein Element der Gruppe Y, Lu, Sc, La, Gd, Tb und Sm, B mindestens ein Element der Gruppe Al, Ga und In und M mindestens ein Element der Gruppe Ce und Pr, vorzugsweise Ce. Als besonders effiziente Leuchtstoffe haben sich die Verbindungen YAG:Ce (Y₃Al₅O₁₂:Ce³⁺), TbYAG:Ce ((TbₓY₁₋ₓ)₃Al₅O₁₂:Ce³⁺, 0<x<1) und GdYAG:Ce ((GdₓY₁ₓ)₃Al₅O₁₂:Ce³⁺, 0<x<1) sowie daraus gebildete Mischkristalle wie beispielsweise GdTbYAG: Ce ((GdₓTb_{y}Y_{1-x-y})₃Al₅O₁₂:Ce³⁺) erwiesen. Dabei kann Al zumindest teilweise durch Ga oder In ersetzt sein. Weiter geeignet sind die Verbindungen SrS:Ce³⁺, Na, SrS:Ce³⁺, Cl, SrS:CeCl₃, CaS:Ce³⁺ und SrSe Ce³⁺.

Mit besonderem Vorteil kann bei dem erfindungsgemäßen Verfahren ein Leuchtstoff mit einer mittleren Korngröße von 10 µm verwendet werden. Bei Verfahren nach dem Stand der Technik ist die Korngröße deutlich geringer und wird so klein wie möglich gehalten, um Sedimentation des Leuchtstoffs in der Vergußmasse zu vermeiden. Nachteiligerweise steigt aber mit kleiner werdender Korngröße die Lichtstreuung an den Leuchtstoffpartikeln, so daß die Lumineszenzkonversionseffizienz insgesamt sinkt. Dieser Nachteil wird mit dem erfindungsgemäßen Verfahren umgangen.

In einer vorteilhaften Weitergestaltung des erfindungsgemäßen Verfahrens wird der Herstellungsprozeß fortgeführt mit dem Vergießen des Bauelements in Epoxid- oder Acrylharz.

Mit besonderem Vorteil können bei dem erfindungsgemäßen Verfahren Halbleiterkörper verwendet werden, die Licht mit einer Zentralwellenlänge unter 460 nm abstrahlen. Die Verwendung solcher Halbleiterkörper ist bei den oben beschriebenen Bauelementen nach dem Stand der Technik nicht sinnvoll, da Licht in diesem Wellenlängenbereich die Vergußmasse, insbesondere handelsübliche Epoxidharze, schädigt und die Vergußmasse dadurch sehr schnell altert. Dieser Nachteil tritt bei dem erfindungsgemäßen Verfahren nicht auf, da ein Teil der Strahlung unmittelbar am Halbleiterkörper konvertiert wird, so daß der Anteil der kurzwelligen Strahlung in der Vergußmasse reduziert ist. Weiterhin ist die Leistungsdichte der Strahlung in der Vergußmasse aufgrund der größeren Entfernung des Vergusses vom dem strahlungsemittierenden Bereich des Halbleiterkörpers geringer.

Mit besonderem Vorteil eignet sich das erfindungsgemäße Verfahren zur Herstellung von Weißlichtleuchtdioden, wie sie in der oben genannten Druckschrift beschrieben sind. Hierbei sind Leuchtstoff und Halbleiterkörper so aufeinander abgestimmt, daß die Farben von Primärlicht und Fluoreszenzlicht zueinander komplementär sind. Durch additive Farbmischung wird der Eindruck weißen Lichts hervorgerufen.

Eine Mehrzahl von Bauelementen, die nach dem erfindungsgemäßen Verfahren hergestellt sind, können zu größeren Beleuchtungseinheiten zusammengefügt werden. Das erfindungsgemäße Verfahren erlaubt mit Vorteil die Herstellung von Bauelementen mit kleinem Volumen beziehungsweise hoher Leuchtdichte, da keine Vergußmasse benötigt wird. Größere Beleuchtungseinheiten, gegebenenfalls mit matrixartiger Anordnung der Bauelemente, zeichnen sich durch besonders hohe Leuchtdichte aus.

Mit besonderem Vorteil eignen sich die erfindungsgemäß hergestellten Bauteile als Lichtquellen in abbildenden Linsensystemen. Da Primär- und Fluoreszenzlicht aus räumlich eng benachbarten und etwa gleich großen Volumina abgestrahlt werden, sind die chromatischen Verzerrungen, die ein solches Linsensystem hervorruft, deutlich geringer als bei Lichtquellen nach dem oben genannten Stand der Technik.

Weitere Merkmale und Vorteile ergeben sich aus der nachfolgenden Beschreibung von zwei Ausführungsbeispielen in Verbindung mit den Figuren 1 bis 4.

Es zeigt
- Figur 1: eine schematische Darstellung einer ersten Ausführungsform eines erfindungsgemäßen Verfahrens,
- Figur 2: eine schematische Darstellung einer zweiten Ausführungsform eines Verfahrens welches nicht Teil der Erfindung ist,
- Figur 3: schematisch die Abstrahlcharakteristik eines nach einem erfindungsgemäßen Verfahren hergestellten Bauelements und
- Figur 4: schematisch die Abstrahlcharakteristik eines Bauelements nach dem Stand der Technik.

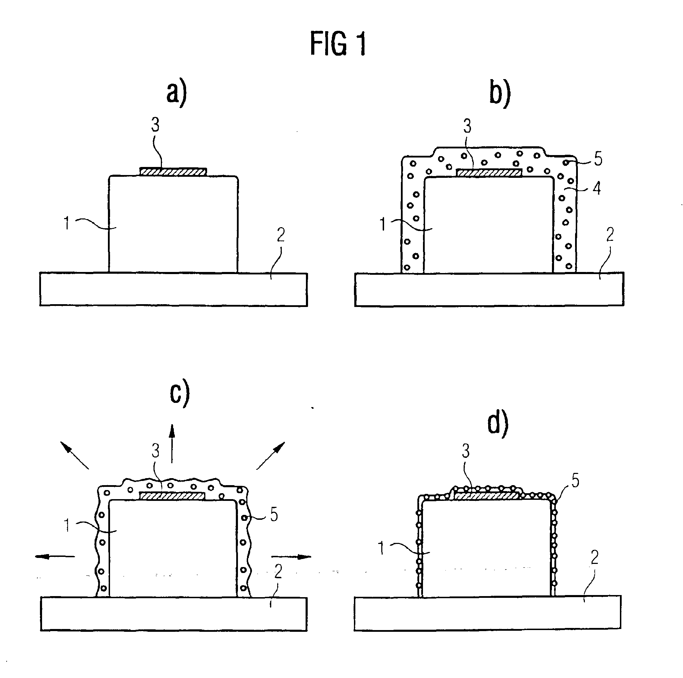

Figur 1 veranschaulicht die Herstellung eines Halbleiterkörpers mit direkt aufgebrachtem Lumineszenzkonversionselement nach dem Verfahren von Patentanspruch 1.

Im ersten Verfahrensschritt, Fig. 1a, wird der Halbleiterkörper 1 nach einer üblichen Fertigungsmethode hergestellt. Der Halbleiterkörper 1 wird auf einen Träger 2 montiert und mit Kontakten 3 versehen. Bezüglich der nachfolgenden Schritte ist die Herstellung keinen prinzipiellen Beschränkungen unterworfen.

Im zweiten Verfahrensschritt, Fig. 1b, wird eine dünne Schicht einer Suspension 4 eines Leuchtstoffs 5 in Butylazetat auf mindestens eine Oberfläche des Halbleiterkörpers 1 aufgebracht. Als Haftvermittler kann beispielsweise PERENOL 45 (Henkel) verwendet werden. Der Leuchtstoff 5 ist in dieser Suspension in hoher Konzentration enthalten mit einem Volumenanteil über 40%. Die Suspensionsschicht wird durch Aufsprühen oder Auftropfen hergestellt. Im letzteren Fall ist die Tropfmenge so bemessen, daß sich eine gleichmäßig dünne, die freien Oberflächen des Halbleiterkörpers 1 umschließende Schicht ergibt. Als Leuchtstoff 5 kann beispielsweise Ce- oder Tb-aktiviertes Yttriumaluminiumgranat oder eine Abwandlung dieses Granats verwendet werden. Wird die Suspensionsschicht 4 durch einen Sprühprozeß aufgebracht, so können auch nur Teilbereiche der Halbleiterkörperoberfläche mit der Suspension 4 bedeckt werden. Weiterhin können der Suspension 4 zur Erzielung einer möglichst homogenen Schicht Rheologieadditive und Netzmittel zugesetzt werden.
Im anschließenden dritten Verfahrensschritt wird das Bauelement getrocknet, wobei das Lösungsmittel Butylazetat gemäß Fig. 1c verdampft, so daß lediglich der Leuchtstoff 5 mit dem Haftvermittler auf dem Halbleiterkörper verbleibt, Fig 1d.

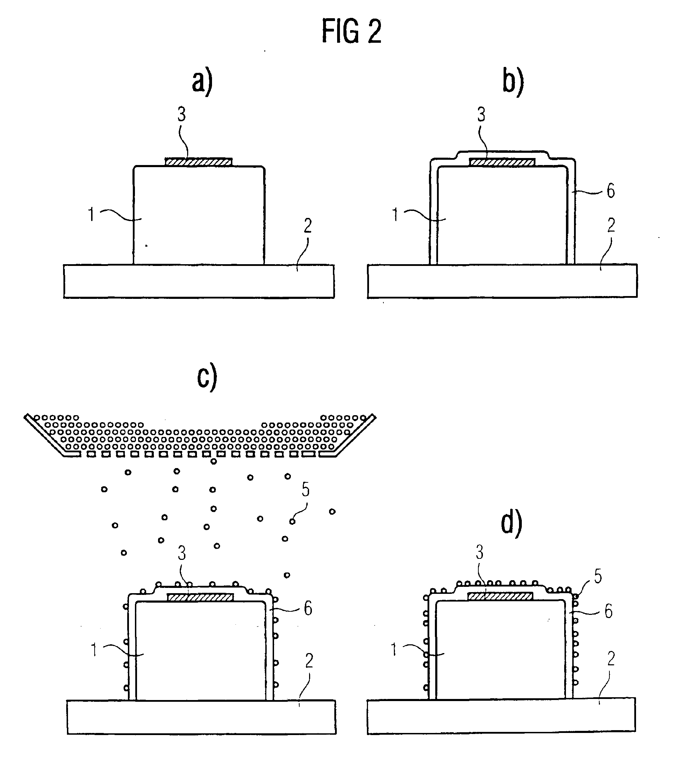

Figur 2 stellt die Herstellung eines Halbleiterkörpers mit direkt aufgebrachtem Lumineszenzkonversionselement (nicht Teil der Erfindung).

Im ersten Verfahrensschritt gemäß Fig. 2a wird wiederum der Halbleiterkörper 1 hergestellt, auf einen Träger 2 montiert und mit Kontakten 3 versehen.

Auf diesen Halbleiterkörper wird im zweiten Schritt eine dünne Schicht Epoxidharz 6 als Haftvermittler aufgesprüht, Fig. 2b. Diese Schicht 6 dient im Gegensatz zu Bauelementen nach dem Stand der Technik nicht als Vergußmasse oder Gehäuse, sondern lediglich als Klebstoff für den aufzubringenden Leuchtstoff 5.

Im dritten Verfahrensschritt gemäß Fig. 2c wird der Leuchtstoff 5 aufgestreut. Nach diesem Schritt haftet der Leuchtstoff 5 in einer gleichmäßig dünnen Schicht auf der Oberfläche des Halbleiterkörpers 1, Fig. 2d. Nach dem Abbinden des Epoxidharzes können weitere Prozeßschritte, beispielsweise der Verguß des Bauelements oder der Einbau in eine Beleuchtungsmatrix erfolgen.

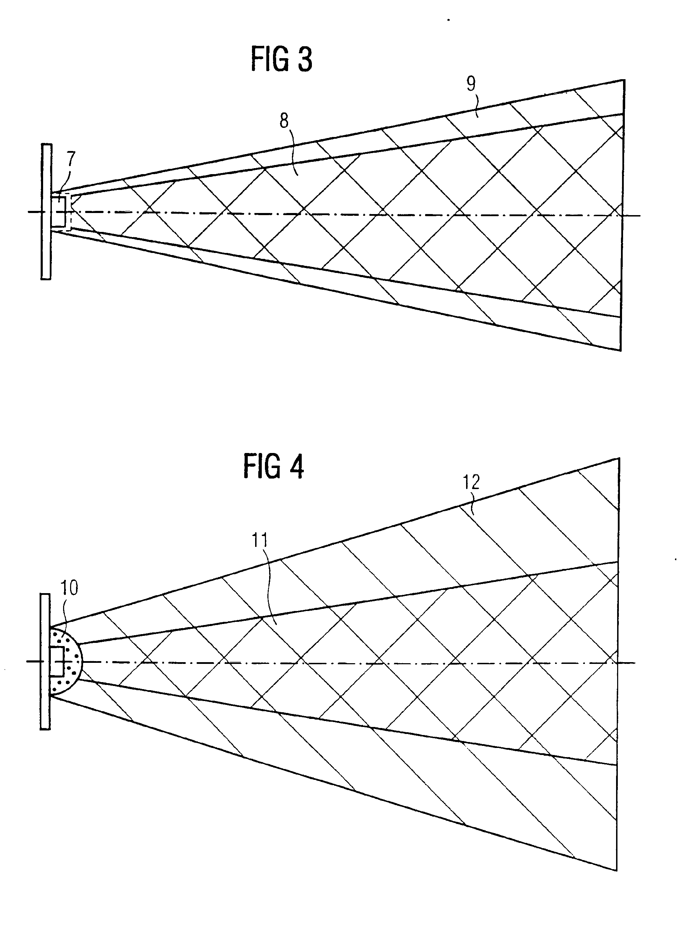

Figur 3 veranschaulicht die Abstrahlcharakteristik eines nach einem erfindungsgemäßen Verfahren hergestellten Bauelements 7. Bei den erfindungsgemäßen Bauelementen 7 werden die Lichtkegel von Primärlicht 8 und Fluoreszenzlicht 9 aus nahezu denselben Volumina abgestrahlt und überdecken sich daher weitestgehend.

Im Vergleich dazu zeigt Fig. 4 die Abstrahlcharakteristik eines Bauelement 10 nach dem Stand der Technik. Solche Bauelemente nach dem Stand der Technik weisen einen auf die optische Achse konzentrierten Primärlichtkegel 11 auf, der aus dem Halbleiterkörper emittiert wird. Das Fluoreszenzlicht 12 wird aus der gesamten Vergußmasse abgestrahlt, so daß der Fluoreszenzlichtkegel 12 deutlich divergenter ist als der Primärlichtkegel 11.

Blickt man im Betrieb entlang der optischen Achse auf ein solches Bauelement 10 nach dem Stand der Technik, so ist das abgestrahlte Mischlicht im Zentrum zur Primärfarbe hin verfärbt und im Außenbereich von einem kreisförmigen Saum umgeben, der die Farbe des Fluoreszenzlichts besitzt.

Hingegen ruft ein nach einem erfindungsgemäßen Verfahren gefertigtes Bauteil 7 einen räumlich gleichmäßigen mischfarbigen Farbeindruck hervor.

## Patentansprüche

1. Verfahren zur Herstellung eines lichtabstrahlenden Halbleiterbauelements, das einen auf ein Trägerelement (2) montierten und elektrisch kontaktierten Halbleiterkörper (1) und ein Lumineszenzkonversionselement enthält, das mindestens einen Leuchtstoff (5) aufweist und das auf den Halbleiterkörper (1) aufgebracht ist,
**gekennzeichnet durch** die Schritte in folgender Reihenfolge
- Herstellung des Halbleiterkörpers (1), Montage auf das Trägerelement (2) und elektrische Kontaktierung,
- schichtartiges Aufbringen einer Suspension (4), die als Lösungsmittel Butylacetat enthält und in die mindestens ein Haftvermittler und der mindestens eine Leuchtstoff (5) eingebracht ist, auf mindestens eine Oberfläche des Halbleiterkörpers (1) **durch** Aufsprühen oder Auftropfen,
- Trocknung des Halbleiterbauelements, wobei der Leuchtstoff (5) auf dem Halbleiterkörper (1) zurückbleibt.

2. Verfahren nach Anspruch 1,
**dadurch gekennzeichnet,**
**daß** als Leuchtstoff (5) anorganische Phosphore, Ce- oder Tbaktivierte Granate, Erdalkalisulfide oder organische Farbstoffe verwendet werden.

3. Verfahren nach einem der Ansprüche 1 oder 2,
**dadurch gekennzeichnet,**
**daß** der Leuchtstoff (5) YAG:Ce, TbYAG:Ce, GdYAG:Ce, GdTbYAG:Ce oder hierauf basierende Gemische enthält, wobei Al zumindest teilweise durch Ga oder In ersetzt sein kann.

4. Verfahren nach einem der Ansprüche 1 bis 3,
**dadurch gekennzeichnet,**
**daß** die mittlere Korngröße des mindestens einen Leuchtstoffs (5) 10 µm beträgt.

5. Verfahren nach einem der Ansprüche 1 bis 4,
**gekennzeichnet durch**
das Eingießen des Bauelements in Epoxidharz oder Acrylharz.

6. Verfahren nach einem der Ansprüche 1 bis 5,
**dadurch gekennzeichnet,**
**daß** die Zentralwellenlänge der von dem Halbleiterkörper (1) im Betrieb emittierten Strahlung unter 460 nm liegt.

7. Verfahren nach einem der Ansprüche 1 bis 6,
**dadurch gekennzeichnet,**
**daß** die Farbe der von dem Halbleiterkörper (1) im Betrieb emittierten Strahlung und die Farbe des von dem mindestens einen Leuchtstoff emittierten Lichts zueinander komplementär sind, so daß der Eindruck weißen Lichts hervorgerufen wird.

## Claims

1. Method for producing a light-emitting semiconductor component which contains a semiconductor body (1) mounted onto and electrically contact-connected to a carrier element (2), and a luminescence conversion element, which comprises at least one luminophore (5) and which is applied to the semiconductor body (1), **characterized by** the steps in the following order:
- producing the semiconductor body (1), mounting onto the carrier element (2) and electrical contact-connection,
- layer-like application of a suspension (4), which contains butyl acetate as solvent and into which at least one adhesion promoter and the at least one luminescent material (5) are introduced, to at least one surface of the semiconductor body (1) by spraying or dropwise application,
- drying the semiconductor component, wherein the luminescent material (5) remains on the semiconductor body (1).

2. Method according to Claim 1,
**characterized**
**in that** inorganic phosphors, Ce- or Tb-activated garnets, alkaline earth metal sulphides or organic dyes are used as luminescent material (5).

3. Method according to either of Claims 1 and 2,
**characterized**
**in that** the luminescent material (5) contains YAG:Ce, TbYAG:Ce, GdYAG:Ce, GdTbYAG:Ce or mixtures based thereon, wherein Al can be replaced at least partly by Ga or In.

4. Method according to any of Claims 1 to 3,
**characterized**
**in that** the average grain size of the at least one luminescent material (5) is 10 µm.

5. Method according to any of Claims 1 to 4,
**characterized by**
casting the component in epoxy resin or acrylic resin.

6. Method according to any of Claims 1 to 5,
**characterized**
**in that** the central wavelength of the radiation emitted by the semiconductor body (1) during operation is less than 460 nm.

7. Method according to any of Claims 1 to 6,
**characterized**
**in that** the colour of the radiation emitted by the semiconductor body (1) during operation and the colour of the light emitted by the at least one luminescent material are complementary to one another, such that the impression of white light is brought about.

## Revendications

1. Procédé de fabrication d'un composant semi-conducteur émettant de la lumière, qui contient un corps semi-conducteur (1) monté sur un élément de support (2) et mis en contact électrique avec ce dernier ainsi qu'un élément de conversion de luminescence qui présente au moins une substance luminescente (5) et qui est appliqué sur le corps semi-conducteur (1),
**caractérisé par** la succession ci-dessous des étapes qui consistent à :
préparer le corps semi-conducteur (1), le monter sur l'élément de support (2) et le mettre en contact électrique,
sur au moins une surface du corps semi-conducteur (1), appliquer couche par couche par pulvérisation ou dépôt de gouttes une suspension (4) qui contient de l'acétate de butyle comme solvant et dans laquelle au moins un adhésif et la ou les substances lumineuses (5) sont incorporées et
sécher le composant semi-conducteur, la substance luminescente (5) restant sur le corps semi-conducteur (1).

2. Procédé selon la revendication 1, **caractérisé en ce qu'**il utilise comme substance luminescente (5) des phosphores organiques, des grenats activés par Ce ou Tb, des sulfures d'éléments alcalino-terreux ou des colorants organiques.

3. Procédé selon l'une des revendications 1 ou 2, **caractérisé en ce que** la substance luminescente (5) contient YAG:Ce, TbYAG:Ce, GdYAG:Ce, GdTbYAG:Ce ou des mélanges de ces derniers, Al pouvant au moins en partie être replacé par Ga ou In.

4. Procédé selon l'une des revendications 1 à 3, **caractérisé en ce que** la taille moyenne des grains de la ou des substances luminescentes (5) est de 10 µm.

5. Procédé selon l'une des revendications 1 à 4, **caractérisé par** l'encapsulation du composant dans une résine époxy ou une résine acrylique.

6. Procédé selon l'une des revendications 1 à 5, **caractérisé en ce que** la longueur d'onde centrale du rayonnement émis en fonctionnement par le corps semi-conducteur (1) est inférieure à 460 nm.

7. Procédé selon l'une des revendications 1 à 6, **caractérisé en ce que** la couleur du rayonnement émis en fonctionnement par le corps semi-conducteur (1) et la couleur de la lumière émise par la ou les substances luminescentes sont complémentaires l'une de l'autre de manière à donner une impression de couleur blanche.
